(19) Europäisches Patentamt / European Patent Office / Office européen des brevets

(11) **EP 3 440 330 B1**

(12) **FASCICULE DE BREVET EUROPEEN**

(45) Date de publication et mention
de la délivrance du brevet:
**27.10.2021 Bulletin 2021/43**

(21) Numéro de dépôt: **17705600.9**

(22) Date de dépôt: **14.02.2017**

(51) Int Cl.:
*F02D 41/14* (2006.01)   *F02D 41/00* (2006.01)

(86) Numéro de dépôt international:
**PCT/EP2017/053307**

(87) Numéro de publication internationale:
**WO 2017/174239 (12.10.2017 Gazette 2017/41)**

(54) **PROCEDE DE DETERMINATION DES EMISSIONS DE POLLUANTS D'UN VEHICULE AU MOYEN DE PARAMETRES MACROSCOPIQUES**

VERFAHREN ZUR BESTIMMUNG DER SCHADSTOFFEMISSIONEN AUS EINEM FAHRZEUG MITHILFE MAKROSKOPISCHER PARAMETER

METHOD FOR DETERMINING POLLUTANT EMISSIONS FROM A VEHICLE USING MACROSCOPIC PARAMETERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.04.2016 FR 1652924**

(43) Date de publication de la demande:
**13.02.2019 Bulletin 2019/07**

(73) Titulaire: **IFP Energies nouvelles
92852 Rueil-Malmaison (FR)**

(72) Inventeurs:
• **THIBAULT, Laurent**
  **69001 Lyon (FR)**
• **DEGEILH, Philippe**
  **75012 Paris (FR)**
• **CORDE, Gilles**
  **91430 Igny (FR)**

(56) Documents cités:
**DE-A1-102007 039 691    DE-A1-102010 046 491
US-A1- 2011 054 768**

• **Matthew Barth ET AL: "DEVELOPMENT OF A COMPREHENSIVE MODAL EMISSIONS MODEL", , 30 avril 2000 (2000-04-30), XP055327849, Extrait de l'Internet: URL:http://www.cert.ucr.edu/cmem/docs/NCHRP_Final_Report.pdf [extrait le 2016-12-09]**
• **Matthew Barth ET AL: "Integrating a Comprehensive Modal Emissions Model into ATMIS Transportation Modeling Frameworks", , 1 août 2001 (2001-08-01), XP055327892, Extrait de l'Internet: URL:http://www.cert.ucr.edu/cmem/docs/PATH-2001-Integrated-CMEM-into-ATMIS.pdf [extrait le 2001-08-01]**

**Description**

La présente invention concerne le domaine de la modélisation des émissions polluantes d'un véhicule, en particulier d'un véhicule automobile.

L'estimation des émissions polluantes des véhicules en usage réel est un enjeu majeur pour faire face aux challenges de santé publique et environnementaux rencontrés dans les grandes métropoles. Pour y parvenir, l'approche principalement utilisée actuellement consiste à instrumenter un véhicule à l'aide d'un Système de Mesure des Emissions Portable (PEMS, de l'anglais « Portable emissions measurement system »). Cependant, le coût de ces systèmes reste prohibitif et ne permet pas leur diffusion à grande échelle. En conséquence, ils ne permettent pas de mesurer les émissions polluantes en usage réel à grande échelle.

Pour pallier ce problème lié à cette instrumentation, il existe différentes approches de modélisations. L'état de l'art des modèles de polluants est constitué de deux grandes familles, les modèles macroscopiques et les modèles microscopiques. Le domaine de l'invention se place ici à l'échelle du véhicule, c'est-à-dire à l'échelle macroscopique. Les modèles haute fréquence (échelle microscopique) modélisant les phénomènes physiques en jeu dans la combustion de manière extrêmement détaillée, comme par exemple décrit dans la demande de brevet FR2984557 (US 2013/0158967), ne sont pas adaptés pour estimer les émissions polluantes en usage réel et à grande échelle, à cause de leur temps de calcul prohibitif, ainsi que par le grand nombre de paramètres requis.

Du côté des approches macroscopiques, le modèle le plus répandu utilise des facteurs d'émissions, c'est-à-dire des coefficients moyens d'émissions par kilomètre parcouru. Ces coefficients dépendent du polluant considéré, de la vitesse moyenne sur le trajet, du type de motorisation (essence/Diesel) et de la norme euro du véhicule. On peut citer notamment la demande de brevet CN102054222A qui couple des acquisitions GPS à des facteurs d'émissions. Cependant, ces approches ne considèrent qu'un comportement moyen du véhicule et du conducteur, et ne permettent donc pas de modéliser leur usage réel. En particulier, l'impact du style de conduite sur les émissions y est négligé. Ils permettent d'estimer les émissions moyennes totales sur un roulage complet d'une durée suffisamment longue.

En outre, de nombreuses études se sont appuyées sur les facteurs d'émissions pour estimer les émissions polluantes. On peut citer notamment le document Liu, H., Chen, X., Wang, Y., & Han, S. (2013). Vehicle Emission and Near-Road Air Quality Modeling for Shanghai, China: Based on Global Positioning System Data from Taxis and Revised MOVES Emission Inventory.Transportation Research Record: Journal of the Transportation Research Board, (2340), 38-48, dans lequel des données GPS connectées sur des taxis sont utilisées en entrée des facteurs d'émission, et le document Sentoff, K. M., Aultman-Hall, L., & Holmén, B. A. (2015). Implications of driving style and road grade for accurate vehicle activity data and emissions estimates. Transportation Research Part D: Transport and Environment, 35, 175-188, qui étudie la précision de l'estimation par facteur d'émission. La conclusion de cette dernière étude montre que la principale source d'erreur provient de la non prise en compte de l'impact du style de conduite et de la pente. Or, pour capter ces phénomènes, il est nécessaire d'utiliser un niveau de modèle plus fin, appelé modèle de polluant microscopique, dont l'entrée est un signal de vitesse véhicule de 1 Hertz.

De plus, il existe déjà de nombreux modèles microscopiques, prévus pour être utilisés dans le cadre d'étude d'ingénierie, inadaptés à une implémentation embarquée, par exemple sur téléphone intelligent (« smartphone ») ou sur un serveur. Les modèles microscopiques les plus connus sont le modèle CMEM (de l'anglais « comprehensive modal emissions » pouvant être traduit par modèle modal approfondi des émissions) et le modèle PHEM (de l'anglais « Passenger Car and Heavy Duty Emission Model » pouvant être traduit par modèle d'émissions de véhicule de tourisme et de véhicule lourd) qui prennent comme données d'entrée des profils de vitesse instantanée. Le modèle CMEM, développé dans les années 1990 par University of California (Riverside), a représenté une contribution significative lors de sa sortie, mais présente aujourd'hui deux inconvénients majeurs : des résultats imprécis dus à des simplifications excessives, et une mauvaise prise en compte des motorisations Diesel.

Quant à lui, le modèle PHEM présente la limitation de ne proposer qu'un modèle type pour de nombreux véhicules relativement différents. Plusieurs documents ont déjà étudié le couplage de ces modèles microscopiques avec des données GPS, fournies par des boitiers connectés installés dans le véhicule. On peut citer notamment le document Pluvinet, P., Gonzalez-Feliu, J., & Ambrosini, C. (2012). GPS data analysis for understanding urban goods movement. Procedia-Social and Behavioral Sciences, 39, 450-462 qui détaille une étude où des données GPS (pour « global positioning system » signifiant géo-positionnement par satellite) réelles ont été utilisées pour alimenter un modèle d'émission microscopique. Cependant cette étude présente une limitation majeure puisque le type de véhicule et le type de moteur ne sont pas pris en compte. La prise en compte du type de véhicule et de motorisation est une problématique majeure pour la modélisation des émissions polluantes en usage réel à grande échelle. En effet, s'il est possible de récupérer les mesures GPS, il est autrement plus compliqué de connaître les spécifications techniques de son moteur et de paramétrer le modèle en conséquence. Toutefois, ces spécifications sont indispensables pour paramétrer les modèles microscopiques précédemment cités. Il s'agit d'une limitation majeure des modèles microscopiques existants qui ne peuvent pas être utilisés pour un déploiement à grande échelle puisqu'ils nécessitent un travail fastidieux de paramétrage manuel pour chaque véhicule considéré.

Les documents XP055327849 et XP055327892 décrivent un procédé selon le préambule de l'invention.

Pour pallier ces inconvénients, la présente invention concerne un procédé de détermination des émissions de polluants d'un véhicule, le procédé est basé sur l'utilisation de mesures de la position et de l'altitude et de la vitesse du véhicule, au moyen de modèles du véhicule, du moteur et du système de post-traitement construits avec des paramètres macroscopiques. Ainsi, il est possible de déterminer les émissions de polluants du véhicule sans instrumentation spécifique, pour un usage réel (grâce aux mesures), avec un temps de calcul limité (grâce aux modèles), et de manière précise (grâce aux modèles construits à l'aide de paramètres macroscopiques).

**Le procédé selon l'invention**

La présente invention concerne un procédé de détermination des émissions de polluants d'un véhicule, ledit véhicule comportant un moteur à combustion interne et un système de post-traitement des gaz d'échappement dudit moteur, dans lequel on acquiert au moins un paramètre macroscopique relatif à la conception dudit véhicule, et dans lequel on construit pour ledit véhicule :

i) un modèle dudit véhicule qui relie ladite position et/ou l'altitude et/ou la vitesse dudit véhicule au couple et au régime dudit moteur au moyen d'au moins un paramètre macroscopique ;

ii) un modèle dudit moteur qui relie ledit couple et ledit régime dudit moteur aux émissions de polluants en sortie dudit moteur au moyen d'au moins un paramètre macroscopique ; et

iii) un modèle dudit système de post-traitement qui relie lesdites émissions de polluants en sortie dudit moteur au moyen aux émissions de polluants en sortie dudit système de post-traitement au moyen d'au moins un paramètre macroscopique.

Pour ce procédé, on réalise les étapes suivantes au moyen d'un téléphone portable:

a) on mesure la position, et l'altitude et la vitesse dudit véhicule ;

b) on détermine ledit couple et ledit régime dudit moteur au moyen dudit modèle de véhicule et desdites mesures ;

c) on détermine les émissions de polluants en sortie dudit moteur au moyen dudit modèle du moteur et dudit couple et dudit régime dudit moteur ; et

d) on détermine les émissions de polluants du véhicule au moyen dudit modèle du système de post-traitement et desdites émissions de polluants en sortie dudit moteur.

Selon un mode de réalisation, on réalise un prétraitement desdites mesures avant l'étape de détermination dudit couple et dudit régime du moteur.

Avantageusement, on réalise ledit prétraitement au moyen d'un sur-échantillonnage et d'un filtrage.

Selon l'invention, on acquiert au moins un paramètre macroscopique choisi parmi : le type de motorisation, la norme d'homologation, la cylindrée du moteur, le couple maximal et le régime du moteur associé, la puissance maximale et le régime du moteur associé, la masse du véhicule, le type de transmission du véhicule, le type de système de post-traitement, le type du système d'injection, l'architecture de la boucle d'air.

Selon l'invention, on acquiert lesdits paramètres macroscopiques depuis une base de données.

Selon une caractéristique, on construit ledit modèle du véhicule au moyen d'un modèle de dynamique du véhicule reliant ladite position et l'altitude et ladite vitesse du véhicule à la puissance estimée dudit moteur au moyen d'au moins un paramètre macroscopique, et au moyen d'un modèle de transmission reliant ladite puissance moteur au régime et au couple du moteur au moyen d'au moins un paramètre macroscopique.

Selon une variante, on construit ledit modèle du moteur au moyen d'un modèle énergétique reliant ledit régime et ledit couple du moteur à des températures et débits de fluides mis en œuvre par la combustion au sein dudit moteur au moyen d'au moins un paramètre macroscopique, et au moyen d'un modèle de polluants en sortie dudit moteur reliant lesdites températures et lesdits débits de fluides aux émissions de polluants en sortie dudit moteur au moyen d'au moins un paramètre macroscopique.

Conformément à une option de réalisation, on construit ledit modèle de polluants en sortie dudit moteur, au moyen d'un modèle quasi-statique et d'un modèle transitoire, ces deux modèles reliant lesdites températures et lesdits débits de fluides auxdites émissions de polluants en sortie dudit moteur au moyen d'au moins un paramètre macroscopique.

De manière avantageuse, ledit modèle transitoire correspond à un coefficient correctif dudit modèle quasi-statique.

Conformément à un mode de réalisation, on construit ledit modèle de post-traitement par discrétisation dudit système de post-traitement en plusieurs tranches et au moyen de l'efficacité de chaque tranche discrétisée.

Selon une mise en œuvre, lesdites émissions du véhicule déterminées sont stockées dans une base de données.

Avantageusement, lesdits polluants sont choisis parmi les oxydes d'azote, les particules, les monoxydes de carbone et/ou les hydrocarbures non brûlés.

Selon l'invention, on mesure la position et l'altitude et la vitesse du véhicule au moyen d'un téléphone portable.

De préférence, on affiche les émissions de polluants déterminées sur un écran d'un système de géolocalisation, d'un téléphone portable, d'un tableau de bord du véhicule ou sur un site internet.

De plus, l'invention concerne un produit programme d'ordinateur téléchargeable depuis un réseau de communication et/ou enregistré sur un support lisible par ordinateur et/ou exécutable par un processeur ou un serveur, comprenant des instructions de code de programme pour la mise en œuvre du procédé selon l'une des caractéristiques précédentes, lorsque ledit programme est exécuté sur un téléphone portable.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les étapes du procédé selon un mode de réalisation de l'invention.

La figure 2 est un histogramme comparant les émissions de NOx pour plusieurs trajets pour une référence et le procédé selon l'invention.

## Description détaillée de l'invention

La présente invention concerne la détermination des émissions de polluants d'un véhicule. Le terme « polluants » désigne les oxydes d'azote (NOx), les particules, les monoxydes de carbone (CO), les hydrocarbures non brûlés (HC). Le procédé selon l'invention permet de déterminer les émissions d'au moins un, avantageusement plusieurs, et de préférence tous, de ces polluants.

Le véhicule comporte un moteur à combustion interne (ci-après désigné par le terme « moteur ») et un système de post-traitement des gaz d'échappement du moteur. Le moteur à combustion interne peut être un moteur essence ou un moteur Diesel. Le moteur peut réaliser à lui seul le déplacement du véhicule, ou peut faire partie d'un système de propulsion hybride. Le système de post-traitement permet de traiter les émissions de polluants en sortie du moteur, diminuant ainsi les émissions de polluants du véhicule. Le système de post-traitement peut comporter un catalyseur d'oxydation pour traiter les hydrocarbures imbrûlés et le monoxyde de carbone, et/ou des catalyseurs DeNOx pour réduire les oxydes d'azote en présence d'oxygène, et/ou différents filtres pour éliminer les particules solides.

Pour le procédé selon l'invention, on acquiert au moins un paramètre macroscopique relatif à la conception du véhicule. On appelle paramètre macroscopique, une caractéristique générale relative au véhicule, son moteur ou son système de post-traitement. Il s'agit de paramètre constant pour un véhicule, correspondant à des données du constructeur du véhicule. Le paramètre est dit macroscopique car il est déterminé à l'échelle du véhicule, et il ne s'agit pas de paramètre microscopique qui peut être déterminé, comme par exemple dans la demande de brevet FR2984557 (US 2013/0158967), à l'échelle d'une maille représentant une petite portion de la chambre de combustion. Les paramètres macroscopiques permettent la construction de modèles macroscopiques représentatifs du véhicule.

Les paramètres macroscopiques peuvent être de trois types :

- des paramètres liés à construction générale du véhicule (par exemple : masse du véhicule, transmission, ...)
- des paramètres liés à la motorisation (par exemple : le type d'injection, la cylindrée, le type de motorisation...), et
- des paramètres liés au système de post-traitement (par exemple : type de post-traitement).

Selon l'invention, on peut acquérir au moins un paramètre macroscopique choisi parmi :

- le type de motorisation (essence, Diesel...),
- le niveau de norme d'homologation (Euro 1, Euro 2, ...),
- la cylindrée du moteur,
- le couple maximal et le régime du moteur associé,
- la puissance maximale et le régime du moteur associé,
- la masse du véhicule,
- le type de transmission du véhicule (type et constitution de boîte de vitesse,...),
- le type de système de post-traitement,
- le type du système d'injection,
- l'architecture de la boucle d'air (présence/absence d'une recirculation des gaz brûlés noté EGR, utilisation d'un turbocompresseur, d'une suralimentation...),

- les dimensions des roues, etc.

Selon l'invention, les paramètres macroscopiques peuvent être obtenus depuis une base de données, qui répertorie les différents véhicules en circulation. Par exemple, les paramètres macroscopiques peuvent être obtenus en indiquant le numéro d'immatriculation du véhicule, la base de données associant le numéro de plaque à sa conception (marque, modèle, motorisation...), et comprenant les paramètres macroscopiques du véhicule.

Selon un exemple alternatif ne faisant pas partie de l'invention, les paramètres macroscopiques peuvent être des données constructeurs renseignés par l'utilisateur, en particulier au moyen d'une interface (par exemple un téléphone intelligent ou un système de géolocalisation).

Notations

Dans la suite de la description, on utilise les notations suivantes :

| | | |
|---|---|---|
| $pos_{GPS}$ | Coordonnées mesurées par géolocalisation dans le repère de Lambert | [m] |
| $alt_{GPS}$ | Altitude mesurée par géolocalisation | [m] |
| $v_{GPS}$ | Vitesse du véhicule mesurée par géolocalisation | [m/s] |
| v | Vitesse du véhicule | [m/s] |
| Ne | Régime du moteur estimé | [tr/min] |
| Cme | Couple du moteur estimé | [Nm] |
| m | Masse du véhicule | [kg] |
| $F_T$ | Effort de traction du véhicule à la roue | [N] |
| $F_{res}$ | Résultante des efforts de frottement subis par le véhicule | [N] |
| $F_{slope}$ | Effort normal subi par le véhicule (gravité) | [N] |
| $F_{brk}$ | Force de freinage mécanique | [N] |
| $\alpha$ | Angle d'inclinaison de la route | [rad] |
| a, b, c | Paramètres du véhicule | [-] |
| Pe | Puissance moteur estimée | [kW] |
| $\eta_{trans}$ | Rendement de la transmission | [-] |
| $R_{MTH-v}$ | Rapport de réduction entre le régime de rotation du moteur et la vitesse du véhicule | [rpm/km/h] |
| PSME | Emissions polluantes en sortie du moteur | [g/s] |
| $PSME_i$ | Emissions du polluant i en sortie du moteur | [g/s] |
| $PSMEL_{-QS}$ | Emissions du polluant i en sortie du moteur pour un régime quasi- statique | [g/h] |
| $NOx_{QS}$ | Masse de Nox par unité de masse de carburant | [g/kg de carburant] |
| COC | Angle de vilebrequin au centre de combustion (50% de conversion d'énergie) | [°CA] |
| $m_{cyl}$ | Masse d'air enfermée dans le cylindre par cycle | [g/$10^3$cm$^3$] |
| $m_{O2}$ | Masse d'oxygène enfermée dans le cylindre par cycle | [g/$10^3$cm$^3$] |
| $a_0$, $a_1$, $a_2$, $a_3$ | Coefficients | [-] |
| $Soot_{QS}$ | Emissions de particules en sortie du moteur en régime quasi-statique | [g/s] |
| BGR | Fraction de gaz brûlés dans le cylindre | [%] |
| $BGR_{dyn}$ | Fraction dynamique de gaz brûlés dans le cylindre | [%] |
| $AF_{ratio}$ | Richesse du mélange dans le cylindre | [-] |
| $AF_{ratio-dyn}$ | Richesse dynamique du mélange dans le cylindre | [-] |
| $Cor_{i-QS2TR}$ | Coefficient de correction pour l'impact des phénomènes transitoires pour le polluant i | [-] |
| PSEE | Emissions polluantes en sortie du système de post-traitement | [g/s] |
| $PSEE_i$ | Emissions du polluant i en sortie du système de post-traitement | [g/s] |
| $Conv_{i,j}$ | Efficacité de conversion de la tranche j du système de post-traitement pour le polluant i | [-] |
| Téch | Température des gaz d'échappement | [K] |
| Qéch | Débit des gaz d'échappement | [g/s] |

Pour ces notations, la dérivée par rapport au temps est notée $\frac{d}{dt}$.

Dans la présente demande, le terme f désigne de manière générale une fonction, qui peut être de tout type.

Selon l'invention, on construit trois modèles macroscopiques afin de déterminer les émissions de polluants. Ces modèles sont paramétrés avec les paramètres macroscopiques acquis, permettant ainsi de rendre le procédé selon l'invention représentatif du véhicule. Il s'agit d'un modèle du véhicule, d'un modèle du moteur et d'un modèle de post-traitement (c'est-à-dire un modèle du système de post-traitement). Ces modèles ne nécessitent pas d'instrumentation ou de matériel spécifiques sur le véhicule.

## Modèle de véhicule

Le modèle du véhicule relie la position et/ou l'altitude et/ou la vitesse du véhicule au couple et au régime du moteur, au moyen d'au moins un paramètre macroscopique. Selon une mise en œuvre de l'invention, pour construire le modèle du véhicule on peut utiliser au moins un des paramètres macroscopiques suivants : masse du véhicule, puissance maximale et le régime du moteur associé, vitesse maximale, type de transmission....

Selon un mode de réalisation de l'invention, on peut construire le modèle du véhicule par association d'un modèle de dynamique du véhicule et d'un modèle de transmission du véhicule. Le modèle de dynamique du véhicule relie la position et la vitesse et l'altitude du véhicule à la puissance estimée du véhicule au moyen d'au moins un paramètre macroscopique, par exemple la masse du véhicule, le type de transmission, les dimensions des roues. Le modèle de transmission du véhicule relie la puissance du véhicule au régime et au couple du moteur, au moyen d'au moins un paramètre macroscopique, par exemple le type de transmission, la puissance maximale et le régime moteur associé.

Le modèle de dynamique du véhicule prend en compte la dynamique du véhicule. Il peut être construit à partir de l'application du principe fondamental de la dynamique du véhicule appliqué sur son axe longitudinal, et peut s'écrire sous la forme suivante :

$$m\frac{dv}{dt} = F_T - F_{res} - F_{slope} - F_{brk}$$

avec : v est la vitesse du véhicule, une entrée du modèle de la dynamique du véhicule.

$F_{res}$ peut être exprimée en fonction de la vitesse sous la forme $F_{res} = a + bv + cv^2$ avec a, b, c des paramètres du véhicule à identifier en fonction des caractéristiques générales du véhicule (paramètres macroscopiques du véhicule).

$F_{slope}$ peut être exprimée en fonction de la masse du véhicule et de l'inclinaison $\alpha$ de la route : $F_{slope} = mg\sin(\alpha)$. L'angle d'inclinaison $\alpha$ est une donnée d'entrée du modèle de la dynamique du véhicule. En effet, l'inclinaison $\alpha$ peut être calculée à partir de l'altitude et de la distance parcourue, elle dépend donc de l'altitude et de la position. Selon un mode de réalisation, l'angle d'inclinaison $\alpha$ peut être déterminé par une formule du type :

$$\alpha = \arctan\left(\frac{\Delta altitude}{\Delta distance}\right)$$

Ces équations permettent d'écrire une formule qui relie la puissance estimée du moteur à la vitesse du véhicule et d'autres paramètres macroscopiques connus ou déterminables. En effet, on peut écrire l'équation :

$$Pe = F_T * v/\eta_{trans}$$

Ainsi, en combinant les différentes équations, il est possible de déterminer une formule qui relie la puissance du moteur à la vitesse et l'altitude du véhicule, au moyen de paramètres macroscopiques connus et constants.

Le modèle de transmission estime le rapport de réduction entre le régime de rotation du moteur thermique et la vitesse du véhicule. Il peut être paramétré en fonction des caractéristiques générales (paramètres macroscopiques) du véhicule, notamment la masse du véhicule, la puissance maximale, le type de transmission, en particulier le nombre de rapports. Ce modèle de transmission utilise seulement la vitesse du véhicule en tant que donnée d'entrée, pour estimer le rapport de réduction :

$$R_{MTH-v} = f(v)$$

La fonction f peut être obtenue notamment à partir d'abaques données par le constructeur.

Ce rapport de réduction peut ensuite être utilisé pour déterminer le régime du moteur. En effet, on peut écrire les relations suivantes :

$$Ne = R_{MTH-v} * v$$

Ensuite, le couple du moteur peut être déterminé en fonction de la puissance (estimée à l'aide du modèle de dynamique du véhicule) et du régime du moteur :

$$Cme = f(Ne, Pe)$$

La fonction f peut être obtenue par des cartographies données par le constructeur.

Modèle du moteur

Le modèle du moteur relie le régime et le couple du moteur aux émissions de polluants en sortie du moteur (c'est-à-dire avant le système de post-traitement), au moyen d'au moins un paramètre macroscopique. Selon une mise en œuvre de l'invention, pour construire le modèle du moteur on peut utiliser au moins un des paramètres macroscopiques suivants : la cylindrée, le type de motorisation, le couple et la puissance , l'architecture de la boucle d'air, la norme d'homologation du véhicule, etc.

Selon un mode de réalisation de l'invention, on peut construire le modèle du moteur par association d'un modèle énergétique et d'un modèle de polluants en sortie du moteur. Le modèle énergétique relie le couple et le régime du moteur à des débits et des températures de fluides mis en œuvre dans le moteur à combustion (carburants, gaz à l'admission, gaz à l'échappement, éventuellement recirculation des gaz brûlés) au moyen d'au moins un paramètre macroscopique, par exemple la cylindrée, le type de motorisation, le couple et la puissance maximaux, l'architecture de la boucle d'air. Le modèle de polluants en sortie moteur relie des débits et des températures de fluides mis en œuvre dans le moteur à combustion interne aux émissions de polluants en sortie du moteur, au moyen d'au moins un paramètre macroscopique, par exemple la norme d'homologation du véhicule, le type de motorisation, l'architecture de la boucle d'air.

Le modèle énergétique permet d'estimer les grandeurs physiques sur le point de fonctionnement courant (régime, couple). Il est paramétré en fonction de paramètres macroscopiques. Les grandeurs physiques estimées sont les débits et températures des fluides mis en œuvre dans le moteur à combustion (carburants, gaz à l'admission, gaz à l'échappement, éventuellement recirculation des gaz brûlés).

Le modèle de polluants en sortie du moteur permet à partir de l'information du régime et du couple du moteur, et des estimations issues du modèle énergétique, d'estimer les émissions polluantes en sortie du moteur. Il peut être paramétré en fonction des caractéristiques générales du véhicule et du moteur : la norme d'homologation du véhicule, le type de motorisation, l'architecture de la boucle d'air, etc.

L'estimation des polluants en sortie moteur peut se faire en deux étapes :

- estimation des émissions en quasi-statique au moyen d'un modèle quasi-statique, et
- estimation de l'impact des phénomènes transitoires au moyen d'un modèle transitoire.

Alternativement, l'estimation des polluants en sortie moteur peut se faire uniquement en une seule étape au moyen du modèle quasi-statique.

Estimer les émissions en quasi-statique d'un moteur sur un point de fonctionnement à un instant donné revient à considérer que ce moteur est en fonctionnement stabilisé sur ce point de fonctionnement.

L'estimation de l'impact des phénomènes transitoires (fonctionnement non stabilisé) permet de prendre en compte les phénomènes transitoires, qui engendrent généralement un surplus d'émissions polluantes.

Les modèles quasi-statiques de polluants peuvent être paramétrés au moyen de paramètres macroscopiques du véhicule et du moteur. Ils permettent à chaque instant d'estimer les émissions polluantes quasi-statiquesen sortie moteur, à partir des estimations de régime et de couple du moteur thermique et des sorties du modèle énergétique. Les modèles quasi-statiques peuvent s'écrire sous la forme :

$$PSME_{i-QS} = f(Ne, Cme)$$

La fonction f peut être de différent type, en fonction du type de polluant étudié.

Par exemple, le modèle quasi-statique de NOx peut être issu des travaux de Gartner, (U. Gartner, G. Hohenberg, H. Daudel and H. Oelschlegel, Development and Application of a Semi-Empirical NOx Model to Various HD Diesel Engines), et peut s'écrire sous la forme :

$$\log\left(NOx_{QS}\right) = a_0 + a_1 * COC + a_2 * m_{cyl} + a_3 * m_{O2}$$

Les coefficients $a_0$, $a_1$, $a_2$, $a_3$ sont obtenus à partir de données expérimentales. Un des avantages de ce modèle est que ces coefficients varient peu d'un moteur à l'autre. Ce point est démontré dans l'article de Gartner précité.

Les particules en sortie du moteur est la combinaison de deux phénomènes : la formation et la post-oxydation dans la chambre de combustion. Ces phénomènes sont au premier ordre influencés par la richesse, le régime, la quantité de carburant, et le taux de gaz brûlés. Ainsi, le modèle statique de particules en sortie du moteur peut s'écrire sous une équation de la forme :

$$Soot_{QS} = f(AF_{ratio}, Ne, Fuel, BGR)$$

La fonction f peut être déterminée par corrélation avec des données expérimentales.

Des modèles similaires peuvent être construits pour les autres polluants.

Pour le mode de réalisation, pour lequel on détermine l'impact des phénomènes transitoires, on peut mettre en œuvre en outre les moyens décrits ci-dessous. Les phénomènes de dynamique de boucle d'air génèrent un écart sur les taux de BGR (fraction de gaz brûlés, liée à la recirculation des gaz d'échappement) et la richesse par rapport au point de fonctionnement stabilisé, ce qui a un impact fort sur les polluants, en particuliers les hydrocarbures HC, le monoxyde de carbone CO et particules. Les modèles d'impact du transitoire sont paramétrés en fonction de paramètres macroscopiques du moteur, en particulier des caractéristiques de la boucle d'air récupérées (atmosphérique/suralimentée, recirculation des gaz brûlés haute pression $EGR_{HP}$ / recirculation des gaz brûlés basse pression $EGR_{BP}$).

Ces modèles permettent d'estimer les fractions de gaz brulés et richesses dynamiques à partir des estimations quasi-statiques et de la variation du couple estimé :

$$BGR_{dyn} = f(BGR, Cme, dCme/dt)$$

$$AF_{ratio-dyn} = f(AF_{ratio}, Cme, dCme/dt)$$

Un coefficient de correction pour chaque polluant peut être calculé en fonction de ces grandeurs dynamiques :

$$Cor_{i-QS2TR} = f(BGR_{dyn}, BGR, AF_{ratio-dyn}, AF_{ratio})$$

Ces coefficients de correction permettent d'estimer les émissions polluantes en sortie moteur en prenant compte les phénomènes transitoires. Pour cela, les émissions de polluants en sortie du moteur peuvent s'écrire par une formule du type :

$$PSME_i = Cor_{i-QS2TR} * PSME_{i-QS}$$

Modèle du post-traitement

Le modèle du post-traitement relie les émissions de polluants en sortie du moteur (c'est-à-dire avant le système de post-traitement) aux émissions de polluants en sortie du système de post-traitement, au moyen d'au moins un paramètre macroscopique. Selon une mise en œuvre de l'invention, pour construire le modèle du moteur on peut utiliser au moins un des paramètres macroscopiques suivants : la cylindrée, la norme d'homologation du véhicule, etc.

Le modèle de post-traitement peut comprendre des sous-modèles pour chaque technologie de dépollution, qui sont associés en fonction de l'architecture du système de dépollution du véhicule. Ces sous-modèles peuvent être paramétrés en fonction de paramètres macroscopiques du véhicule tels que la norme d'homologation, la cylindrée, etc. Par exemple, les différentes technologies de dépollution peuvent être :

- TWC, de l'anglais « Three-way catalytic converters » signifiant catalyseur trois voies,
- GPF (pour moteur essence), de l'anglais « gasoline particle filter » signifiant filtre à particules pour essence,
- DOC (pour moteur diesel), de l'anglais « Diesel oxidation catalyst », signifiant catalyseur à oxydation pour Diesel,
- DPF (pour moteur diesel), de l'anglais « Diesel particle filter », signifiant filtre à particules pour Diesel,
- LNT (pour moteur Diesel), de l'anglais « lean Nox trap », signifiant piège à Nox,
- SCR (pour moteur Diesel), de l'anglais « Selective catalytic reduction », signifiant réduction catalytique sélective.

Le modèle de post-traitement permet d'estimer les émissions de polluants en sortie du système de post-traitement à partir des estimations de température, débits, et émissions polluantes en sortie du moteur. Le modèle de post-traitement peut être construit en discrétisant le système de post-traitement en plusieurs tranches (ou couches), et par association de l'efficacité $Conv_{i,j}$ de chaque tranche discrétisée. Selon un exemple, le modèle de post-traitement peut s'écrire :

$$PSEE_i = \prod_{j=1}^{Nb\ pain} Conv_{i,j}(T_{éch}, Q_{éch}) * PSME_i$$

L'efficacité des tranches du système de post-traitement peut être déterminée à partir de cartographies du constructeur.

Etapes du procédé de détermination des émissions de polluant

Une fois les modèles construits pour le véhicule considéré, le procédé selon l'invention comporte les étapes suivantes :

1) Mesure de géolocalisation
2) (étape facultative) Prétraitement des mesures
3) Détermination du couple et du régime moteur
4) Détermination des émissions de polluants en sortie du moteur
5) Détermination des émissions de polluants du véhicule
6) (étape facultative) Stockage des données

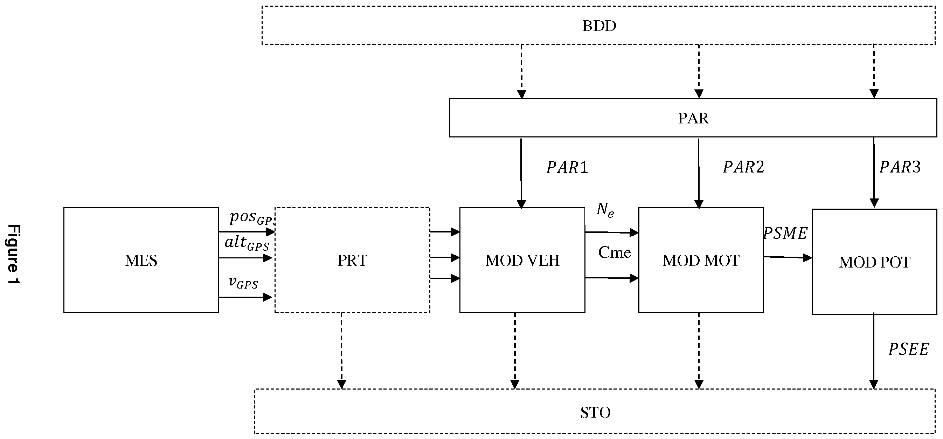

La figure 1 illustre, de manière schématique et non limitative, les étapes du procédé selon un mode de réalisation de l'invention. Sur cette figure, les traits pointillés indiquent des éléments facultatifs du procédé.

Préalablement aux étapes du procédé, les différents modèles (modèle du véhicule MOD VEH, modèle du moteur MOD MOT et modèle du post-traitement MOD POT) sont construits. Ces modèles sont construits à partir de paramètres macroscopiques PAR. Les paramètres macroscopiques PAR sont obtenus depuis une base de données BDD, qui répertorie les différents véhicules en circulation. Par exemple, les paramètres macroscopiques PAR peuvent être obtenus en indiquant le numéro d'immatriculation du véhicule, la base de données BDD associant le numéro de plaque à la conception du véhicule (marque, modèle, motorisation...), et comprenant les paramètres macroscopiques du véhicule.

Une première série de paramètres macroscopiques PAR1 est utilisée pour la construction du modèle du véhicule MOD VEH. Cette première série de paramètres macroscopiques PAR1 peut comprendre les paramètres suivants : la masse du véhicule, la puissance maximale et le régime du moteur associé, la vitesse maximale, le type de transmission (liste non limitative).

Une deuxième série de paramètres macroscopiques PAR2 est utilisée pour la construction du modèle du moteur MOD MOT. Cette deuxième série de paramètres macroscopiques PAR2 peut comprendre les paramètres suivants : la cylindrée, le type de motorisation, le couple et la puissance maximums, l'architecture de la boucle d'air, la norme d'homologation du véhicule (liste non limitative).

Une troisième série de paramètres macroscopiques PAR3 est utilisée pour la construction du modèle du post-traitement MOD POT. Cette troisième série de paramètres macroscopiques PAR3 peut comprendre les paramètres suivants : la cylindrée, la norme d'homologation du véhicule (liste non limitative).

Ces trois modèles peuvent être construits selon l'une des variantes de réalisation décrites ci-dessus.

La première étape consiste en une étape de mesure MES de géolocalisation. Lors de cette étape, on peut mesurer la position $pos_{GPS}$, et l'altitude $alt_{GPS}$ et la vitesse $v_{GPS}$ du véhicule. La prise en compte de l'altitude $alt_{GPS}$ permet notamment de prendre en compte la pente de la route. On réalise les trois mesures, de manière à avoir l'information la plus précise possible concernant la géolocalisation du véhicule, car on peut prendre alors en compte le style de conduite, et l'accélération du véhicule. Cette mesure peut être réalisée à l'aide d'un système de géolocalisation, par exemple de type GPS (pour « global positioning system » signifiant géo-positionnement par satellite) ou de type Galileo, ou selon l'invention au moyen d'un téléphone intelligent (« smartphone »), etc. Dans le cas d'un téléphone intelligent, celui-ci peut être équipé d'un système de géolocalisation, alternativement selon un exemple ne faisant pas partie de l'invention, les mesures peuvent être mises en œuvre par d'autres moyens, notamment par triangulation.

La deuxième étape, qui est une étape facultative, est une étape de prétraitement PRT des signaux de mesure. Cette étape permet d'améliorer la qualité des signaux mesurés avant de les utiliser. Cette étape peut notamment être intéressante, si les mesures sont réalisées à partir d'un téléphone intelligent, car les mesures issues d'un tel dispositif peuvent être quelque peu imprécises. Ce prétraitement peut être variable, car il est dépendant de la qualité des données d'entrée. Selon un mode de réalisation de l'invention, le prétraitement PRT peut comprendre un sur-échantillonnage des signaux, puis un filtrage. En sortie de cette étape, on retrouve donc des signaux relatifs à la position $pos_{GPS}$, et/ou l'altitude $alt_{GPS}$ et/ou la vitesse $v_{GPS}$ du véhicule, ces signaux ayant été prétraités.

La troisième étape concerne la détermination du couple et du régime moteur. Cette étape est mise en œuvre au moyen du modèle du véhicule MOD VEH, qui détermine le couple Cme et le régime Ne du moteur, en fonction des données de géolocalisation : la position $pos_{GPS}$, et l'altitude $alt_{GPS}$ et la vitesse $v_{GPS}$ du véhicule.

La quatrième étape concerne la détermination des émissions polluantes en sortie du moteur, cette étape est mise en œuvre au moyen du modèle du moteur MOD MOT, qui détermine les émissions de polluants en sortie du moteur PSME, en fonction du couple Cme et du régime Ne du moteur.

La cinquième étape concerne la détermination des émissions de polluants du véhicule, c'est-à-dire en sortie du système de post-traitement. La détermination des émissions de polluants peut être réalisée à chaque instant, par exemple à une fréquence de 1Hz. De plus, il est également possible de déterminer le cumul des émissions de polluants sur un trajet réalisé. Cette étape est mise en œuvre au moyen du modèle de post-traitement MOD POT, qui détermine les émissions de polluants en sortie du système de post-traitement PSEE, en fonction des émissions de polluants en sortie du moteur PSME.

La sixième étape, facultative, concerne le stockage des données. Une fois que les émissions de polluants du véhicule PSEE sont déterminées, celles-ci peuvent être stockées STO (enregistrées), en particulier dans une base de données (différente de la base de données qui comportent les paramètres macroscopiques). Ce stockage STO peut concerner uniquement les émissions de polluants du véhicule PSEE, mais peut aussi concerner les données déterminées après chaque étape du procédé : les mesures prétraitées et/ou le couple Cme et le régime Ne du moteur et/ou les émissions de polluants en sortie du moteur PSME. Ces informations permettent un suivi des usages réels et des émissions associées avec une bonne résolution spatiale et temporelle. Ces informations peuvent par exemple permettre d'évaluer la pertinence environnementale des infrastructures routières à l'échelle d'une rue, identifier des pics d'émissions localisés, identifier l'impact du style de la conduite sur les émissions, etc.

Cette base de données peut associer les émissions instantanées aux données cartographiques pour constituer une carte des émissions polluantes réelles. Il est donc possible de tirer des conclusions à l'échelle d'une portion de route, d'un trajet complet ou même d'une zone géographique selon les besoins. Lors de cette étape, il est également possible d'afficher les émissions de polluants en sortie du véhicule PSEE, par exemple sur un écran d'un système de géolocalisation (GPS, Galiléo), d'un téléphone intelligent, sur le tableau de bord du véhicule, sur un site internet, etc. Ainsi, il est possible d'informer l'utilisateur ou tout autre personne (par exemple un gestionnaire de flotte de véhicules, un responsable d'infrastructure routière...) de la pollution émise sur un trajet ou sur une route.

Le procédé selon l'invention peut être utilisé pour les véhicules automobiles. Toutefois, il peut être utilisé dans le domaine du transport routier, le domaine des deux-roues, le domaine ferroviaire, le domaine naval, le domaine aéronautique, le domaine des aéroglisseurs, et le domaine des véhicules amphibies...

L'invention concerne par ailleurs un produit programme d'ordinateur téléchargeable depuis un réseau de communication et/ou enregistré sur un support lisible par ordinateur et/ou exécutable par un processeur ou un serveur. Ce programme comprend des instructions de code de programme pour la mise en œuvre du procédé tel que décrit ci-dessus, lorsque le programme est exécuté sur un téléphone portable.

Le procédé selon l'invention présente donc les avantages suivants :

- Le procédé selon l'invention permet la prise en compte de la pente, de l'accélération et du style de conduite, pour déterminer de manière précise les émissions polluantes,
- La modélisation des polluants selon l'invention est réalisée par une approche physique nécessitant uniquement la connaissance de paramètres macroscopiques, disponibles facilement, par exemple à partir de la plaque d'immatriculation d'un véhicule,
- Le procédé selon l'invention est adapté aux paramètres réels de chacun des véhicules,
- Le procédé selon l'invention ne nécessite pas de données mesurées au banc moteur, qui seraient spécifiques à un véhicule,
- Le procédé selon l'invention permet de modéliser une classe de véhicule,

EP 3 440 330 B1

- Le procédé selon l'invention ne nécessite pas d'instrumentation ou de matériel spécifique, en effet, les émissions de polluants peuvent être déterminées au moyen d'un téléphone intelligent,
- Le procédé selon l'invention permet de placer les émissions polluantes sur les routes traversées,
- L'invention permet d'estimer l'efficacité écologique d'une infrastructure routière existante, sans nécessiter l'installation coûteuse de capteurs de polluants spécifiques,
- Elle permet également d'observer l'impact d'une réglementation portant sur la circulation ou sur les véhicules sur les émissions polluantes en usage réel.

Exemple

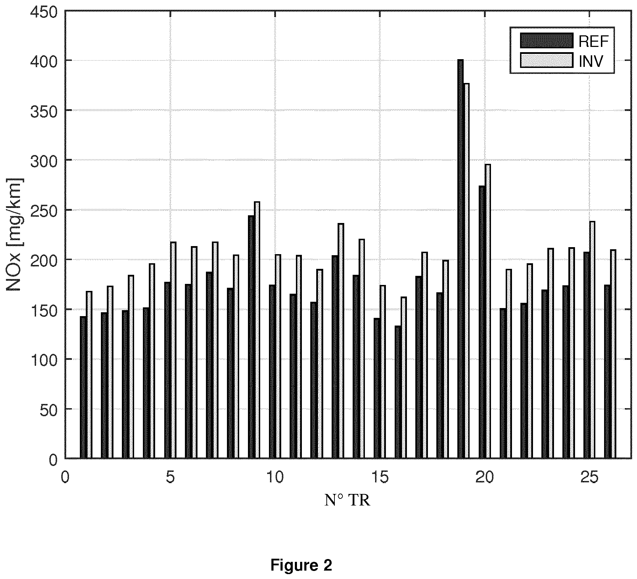

Afin de montrer l'intérêt du procédé selon l'invention, on réalise un exemple pour comparer les émissions de NOx mesurées et les émissions estimées au moyen des modèles mis en œuvre dans le procédé selon l'invention. La figure 2 illustre une comparaison des résultats obtenus, en termes d'émissions de NOx, pour 26 trajets différents, indiqués par leur numéro (N° trajet). Sur cet histogramme, la référence REF est issue d'une campagne d'essais, et les valeurs estimées sont obtenues par le procédé selon l'invention INV (en utilisant les variantes de réalisation des modèles détaillés ci-dessus). On observe une bonne cohérence des résultats.

**Revendications**

1. Procédé de détermination d'une quantité des émissions de polluants d'un véhicule, ledit véhicule comportant un moteur à combustion interne et un système de post-traitement des gaz d'échappement dudit moteur, dans lequel on acquiert au moins un paramètre macroscopique (PAR) relatif à la conception dudit véhicule depuis une base de données qui répertorie les différents véhicules en circulation, ledit au moins un paramètre macroscopique étant choisi parmi : le type de motorisation, la norme d'homologation, la cylindrée du moteur, le couple maximal et le régime du moteur associé, la puissance maximale et le régime du moteur associé, la masse du véhicule, le type de transmission du véhicule, le type de système de post-traitement, le type du système d'injection, l'architecture de la boucle d'air, et dans lequel on construit pour ledit véhicule :

   i) un modèle dudit véhicule (MOD VEH) qui relie ladite position et l'altitude et la vitesse dudit véhicule au couple et au régime dudit moteur au moyen d'au moins un paramètre macroscopique (PAR) ;
   ii) un modèle dudit moteur (MOD MOT) qui relie ledit couple et ledit régime dudit moteur aux émissions de polluants en sortie dudit moteur au moyen d'au moins un paramètre macroscopique (PAR) ; et
   iii) un modèle dudit système de post-traitement (MOD POT) qui relie lesdites émissions de polluants en sortie dudit moteur au moyen aux émissions de polluants en sortie dudit système de post-traitement au moyen d'au moins un paramètre macroscopique (PAR) ;

   **caractérisé en ce qu'**on réalise les étapes suivantes, au moyen d'un téléphone portable :

   a) on mesure la position ($pos_{GPS}$), et l'altitude ($alt_{GPS}$) et la vitesse ($v_{GPS}$) dudit véhicule ;
   b) on détermine ledit couple (Cme) et ledit régime (Ne) dudit moteur au moyen dudit modèle de véhicule (MOD VEH) et desdites mesures ;
   c) on détermine les émissions de polluants en sortie dudit moteur (PSME) au moyen dudit modèle du moteur (MOD MOT) et dudit couple (Cme) et dudit régime (Ne) dudit moteur ; et
   d) on détermine une quantité des émissions de polluants du véhicule (PSEE) à chaque instant ou pour un trajet réalisé, au moyen dudit modèle du système de post-traitement (MOD POT) et desdites émissions de polluants en sortie dudit moteur (PSME).

2. Procédé selon la revendication 1, dans lequel on réalise un prétraitement (PRT) desdites mesures avant l'étape de détermination dudit couple (Cme) et dudit régime (Ne) du moteur.

3. Procédé selon la revendication 2, dans lequel on réalise ledit prétraitement (PRT) au moyen d'un sur-échantillonnage et d'un filtrage.

4. Procédé selon l'une des revendications précédentes, dans lequel on construit ledit modèle du véhicule (MOD VEH) au moyen d'un modèle de dynamique du véhicule reliant ladite position et l'altitude et ladite vitesse du véhicule à la puissance estimée dudit moteur au moyen d'au moins un paramètre macroscopique (PAR), et au moyen d'un modèle de transmission reliant ladite puissance moteur au régime et au couple du moteur au moyen d'au moins un paramètre macroscopique (PAR).

5. Procédé selon l'une des revendications précédentes, dans lequel on construit ledit modèle du moteur (MOD MOT) au moyen d'un modèle énergétique reliant ledit régime et ledit couple du moteur à des températures et débits de fluides mis en œuvre par la combustion au sein dudit moteur au moyen d'au moins un paramètre macroscopique (PAR), et au moyen d'un modèle de polluants en sortie dudit moteur reliant lesdites températures et lesdits débits de fluides aux émissions de polluants en sortie dudit moteur au moyen d'au moins un paramètre macroscopique (PAR).

6. Procédé selon la revendication 5, dans lequel on construit ledit modèle de polluants en sortie dudit moteur, au moyen d'un modèle quasi-statique et d'un modèle transitoire, ces deux modèles reliant lesdites températures et lesdits débits de fluides auxdites émissions de polluants en sortie dudit moteur au moyen d'au moins un paramètre macroscopique (PAR).

7. Procédé selon la revendication 6, dans lequel ledit modèle transitoire correspond à un coefficient correctif dudit modèle quasi-statique.

8. Procédé selon l'une des revendications précédentes, dans lequel on construit ledit modèle de post-traitement (MOD POT) par discrétisation dudit système de post-traitement en plusieurs tranches et au moyen de l'efficacité de chaque tranche discrétisée.

9. Procédé selon l'une des revendications précédentes, dans lequel lesdites émissions du véhicule déterminées sont stockées (STO) dans une base de données.

10. Procédé selon l'une des revendications précédentes, dans lequel lesdits polluants sont choisis parmi les oxydes d'azote, les particules, les monoxydes de carbone et/ou les hydrocarbures non brûlés.

11. Procédé selon l'une des revendications précédentes, dans lequel on affiche les émissions de polluants (PSEE) déterminées sur un écran d'un système de géolocalisation, d'un téléphone portable, d'un tableau de bord du véhicule ou sur un site internet.

12. Produit programme d'ordinateur téléchargeable depuis un réseau de communication et/ou enregistré sur un support lisible par ordinateur et/ou exécutable par un processeur ou un serveur, comprenant des instructions de code de programme pour la mise en œuvre du procédé selon l'une des revendications précédentes, lorsque ledit programme est exécuté sur un téléphone portable.

**Patentansprüche**

1. Verfahren zur Bestimmung einer Menge der Schadstoffemissionen eines Fahrzeugs, wobei das Fahrzeug einen Verbrennungsmotor und ein Nachbehandlungssystem der Abgase des Motors aufweist, wobei mindestens ein makroskopischer Parameter (PAR) bezüglich des Designs des Fahrzeugs ausgehend von einer Datenbank erfasst wird, die die verschiedenen in Betrieb befindlichen Fahrzeuge auflistet, wobei der mindestens eine makroskopische Parameter ausgewählt wird aus: dem Antriebstyp, der Zulassungsnorm, dem Hubraum des Motors, dem maximalen Drehmoment und der zugeordneten Drehzahl des Motors, der maximalen Leistung und der zugeordneten Drehzahl des Motors, der Masse des Fahrzeugs, dem Getriebetyp des Fahrzeugs, dem Typ des Nachbehandlungssystems, dem Typ des Einspritzsystems, der Architektur des Luftkreislaufs, und wobei für das Fahrzeug konstruiert wird:

i) ein Modell des Fahrzeugs (MOD VEH), das die Position und die Höhe und die Geschwindigkeit des Fahrzeugs mit dem Drehmoment und der Drehzahl des Motors mittels mindestens eines makroskopischen Parameters (PAR) verbindet;
ii) ein Modell des Motors (MOD MOT), das das Drehmoment und die Drehzahl des Motors mit den Schadstoffemissionen am Ausgang des Motors mittels mindestens eines makroskopischen Parameters (PAR) verbindet; und
iii) ein Modell des Nachbehandlungssystems (MOD POT), das die Schadstoffemissionen am Ausgang des Motors mittels mit den Schadstoffemissionen am Ausgang des Nachbehandlungssystems mittels mindestens eines makroskopischen Parameters (PAR) verbindet;

**dadurch gekennzeichnet, dass** die folgenden Schritte mittels eines Mobiltelefons durchgeführt werden:

a) die Position ($pos_{GPS}$) und die Höhe ($alt_{GPS}$) und die Geschwindigkeit ($v_{GPS}$) des Fahrzeugs werden gemessen;
b) das Drehmoment (Cme) und die Drehzahl (Ne) des Motors werden mittels des Fahrzeugmodells (MOD VEH) und der Messwerte bestimmt;
c) die Schadstoffemissionen am Ausgang des Motors (PSME) werden mittels des Modells des Motors (MOD MOT) und des Drehmoments (Cme) und der Drehzahl (Ne) des Motors bestimmt; und
d) eine Menge der Schadstoffemissionen des Fahrzeugs (PSEE) in jedem Moment oder für eine zurückgelegte Strecke wird mittels des Modells des Nachbehandlungssystems (MOD POT) und der Schadstoffemissionen am Ausgang des Motors (PSME) bestimmt.

2. Verfahren nach Anspruch 1, wobei eine Vorbehandlung (PRT) der Messwerte vor dem Schritt der Bestimmung des Drehmoments (Cme) und der Drehzahl (Ne) des Motors durchgeführt wird.

3. Verfahren nach Anspruch 2, wobei die Vorbehandlung (PRT) mittels einer Überabtastung und einer Filterung durchgeführt wird.

4. Verfahren nach einem der vorhergehenden Ansprüche, wobei das Modell des Fahrzeugs (MOD VEH) mittels eines Dynamikmodells des Fahrzeugs, das die Position und die Höhe und die Geschwindigkeit des Fahrzeugs mit der geschätzten Leistung des Motors mittels mindestens eines makroskopischen Parameters (PAR) verbindet, und mittels eines Getriebemodells konstruiert wird, das die Motorleistung mit der Drehzahl und dem Drehmoment des Motors mittels mindestens eines makroskopischen Parameters (PAR) verbindet.

5. Verfahren nach einem der vorhergehenden Ansprüche, wobei das Modell des Motors (MOD MOT) mittels eines energetischen Modells, das die Drehzahl und das Drehmoment des Motors mit Temperaturen und Fluiddurchsätzen, die durch die Verbrennung innerhalb des Motors verwendet werden, mittels mindestens eines makroskopischen Parameters (PAR) verbindet, und mittels eines Modells von Schadstoffen am Ausgang des Motors konstruiert wird, das die Temperaturen und die Fluiddurchsätze mit den Schadstoffemissionen am Ausgang des Motors mittels mindestens eines makroskopischen Parameters (PAR) verbindet.

6. Verfahren nach Anspruch 5, wobei das Modell von Schadstoffen am Ausgang des Motors mittels eines quasistatischen Modells und eines Übergangsmodells konstruiert wird, wobei diese zwei Modelle die Temperaturen und die Fluiddurchsätze mit den Schadstoffemissionen am Ausgang des Motors mittels mindestens eines makroskopischen Parameters (PAR) verbinden.

7. Verfahren nach Anspruch 6, wobei das Übergangsmodell einem Korrekturkoeffizienten des quasistatischen Modells entspricht.

8. Verfahren nach einem der vorhergehenden Ansprüche, wobei das Nachbehandlungsmodell (MOD POT) durch Diskretisierung des Nachbehandlungssystems in mehrere Teilabschnitte und mittels der Wirksamkeit jedes diskretisierten Teilabschnitts konstruiert wird.

9. Verfahren nach einem der vorhergehenden Ansprüche, wobei die bestimmten Emissionen des Fahrzeugs in einer Datenbank gespeichert werden (STO).

10. Verfahren nach einem der vorhergehenden Ansprüche, wobei die Schadstoffe aus den Stickoxiden, den Partikeln, den Kohlenmonoxiden und/oder den unverbrannten Kohlenwasserstoffen ausgewählt werden.

11. Verfahren nach einem der vorhergehenden Ansprüche, wobei die bestimmten Schadstoffemissionen (PSEE) auf einem Bildschirm eines Geolokalisierungssystems, eines Mobiltelefons, eines Armaturenbretts des Fahrzeugs oder auf einer Internetseite angezeigt werden.

12. Computerprogrammprodukt, das von einem Kommunikationsnetzwerk herunterladbar und/oder auf einem computerlesbaren Träger gespeichert und/oder von einem Prozessor oder einem Server ausführbar ist, das Programmcodeanweisungen für die Durchführung des Verfahrens nach einem der vorhergehenden Ansprüche enthält, wenn das Programm auf einem Mobiltelefon ausgeführt wird.

**Claims**

1. Process for determining an amount of pollutant emissions from a vehicle, said vehicle having an internal combustion engine and a system for aftertreatment of the exhaust gases of said engine, wherein at least one macroscopic parameter (PAR) relating to the design of said vehicle is acquired from a database which lists the various vehicles in circulation, said at least one macroscopic parameter being chosen from: the type of motorization, the certification standard, the engine swept volume, the maximum torque and the rating of the associated engine, the maximum power and the rating of the associated engine, the weight of the vehicle, the type of transmission of the vehicle, the type of aftertreatment system, the type of injection system, the architecture of the air loop, and wherein the following are constructed for said vehicle:

   i) a model of said vehicle (MOD VEH) which connects said position and the altitude and the speed of said vehicle to the torque and to the rating of said engine by means of at least one macroscopic parameter (PAR);
   ii) a model of said engine (MOD MOT) which connects said torque and said rating of said engine to the pollutant emissions leaving said engine by means of at least one macroscopic parameter (PAR); and
   iii) a model of said aftertreatment system (MOD POT) which connects said pollutant emissions leaving said engine by means to the pollutant emissions leaving said aftertreatment system by means of at least one macroscopic parameter (PAR);

   **characterized in that** the following steps are carried out by means of a mobile phone:

   a) the position ($pos_{GPS}$) and the altitude ($alt_{GPS}$) and the speed ($v_{GPS}$) of said vehicle are measured;
   b) said torque ($Cme$) and said rating ($Ne$) of said engine are determined by means of said vehicle model (MOD VEH) and said measurements;
   c) the pollutant emissions leaving said engine (PSME) are determined by means of said engine model (MOD MOT) and said torque ($Cme$) and said rating ($Ne$) of said engine; and
   d) at each instant or for a journey which has been made, an amount of the pollutant emissions from the vehicle (PSEE) is determined by means of said aftertreatment system model (MOD POT) and said pollutant emissions leaving said engine (PSME).

2. Process according to Claim 1, wherein a preprocessing (PRT) of said measurements is carried out before the step of determining said torque ($Cme$) and said rating ($Ne$) of the engine.

3. Process according to Claim 2, wherein said preprocessing (PRT) is carried out by means of an oversampling and a filtering.

4. Process according to one of the preceding claims, wherein said vehicle model (MOD VEH) is constructed by means of a model of the dynamics of the vehicle connecting said position and the altitude and said speed of the vehicle to the estimated power of said engine by means of at least one macroscopic parameter (PAR), and by means of a model of the transmission connecting said engine power to the rating and to the torque of the engine by means of at least one macroscopic parameter (PAR).

5. Process according to one of the preceding claims, wherein said engine model (MOD MOT) is constructed by means of an energetic model connecting said rating and said torque of the engine to temperatures and flow rates of fluids used by the combustion within said engine by means of at least one macroscopic parameter (PAR), and by means of a model of pollutants leaving said engine connecting said temperatures and said flow rates of fluids to the pollutant emissions leaving said engine by means of at least one macroscopic parameter (PAR).

6. Process according to Claim 5, wherein said model of pollutants leaving said engine is constructed by means of a quasi-static model and of a transient model, these two models connecting said temperatures and said flow rates of fluids to said pollutant emissions leaving said engine by means of at least one macroscopic parameter (PAR) .

7. Process according to Claim 6, wherein said transit model corresponds to a corrective coefficient of said quasi-static model.

8. Process according to one of the preceding claims, wherein said aftertreatment model (MOD POT) is constructed by discretization of said aftertreatment system into several slices and by means of the efficiency of each discretized slice.

9. Process according to one of the preceding claims, wherein said vehicle emissions determined are stored (STO) in a database.

10. Process according to one of the preceding claims, wherein said pollutants are chosen from nitrogen oxides, particulates, carbon monoxides and/or unburnt hydrocarbons.

11. Process according to one of the preceding claims, wherein the pollutant emissions (PSEE) determined are displayed on a screen of a geolocation system, of a mobile phone, of a dashboard of the vehicle or on an Internet site.

12. Computer program product downloadable from a communication network and/or saved on a medium that can be read by a computer and/or that can be executed by a processor or a server, comprising program code instructions for the implementation of the process according to one of the preceding claims, when said program is executed on a mobile phone.

Figure 1

Figure 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2984557
- US 20130158967 A
- CN 102054222 A

**Littérature non-brevet citée dans la description**

- **LIU, H. ; CHEN, X. ; WANG, Y. ; HAN, S.** Vehicle Emission and Near-Road Air Quality Modeling for Shanghai, China: Based on Global Positioning System Data from Taxis and Revised MOVES Emission Inventory. *Transportation Research Record: Journal of the Transportation Research Board,* 2013, vol. 2340, 38-48
- **PLUVINET, P. ; GONZALEZ-FELIU, J. ; AMBROSINI, C.** GPS data analysis for understanding urban goods movement. *Procedia-Social and Behavioral Sciences,* 2012, vol. 39, 450-462